(19) Europäisches Patentamt
European Patent Office
Office européen des brevets

(11) **EP 4 786 991 A1**

(12) **EUROPÄISCHE PATENTANMELDUNG**

(43) Veröffentlichungstag:
**05.08.2026 Patentblatt 2026/32**

(21) Anmeldenummer: **25219726.4**

(22) Anmeldetag: **01.12.2025**

(51) Internationale Patentklassifikation (IPC):
*G01R 15/20* (2006.01)     *G01R 19/00* (2006.01)
*G01R 21/00* (2006.01)

(52) Gemeinsame Patentklassifikation (CPC):
**G01R 15/202; G01R 19/0092;** G01R 21/006

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH LA MA MD TN**

(30) Priorität: **29.01.2025 AT 500572025**

(71) Anmelder: **go-e GmbH
9560 Feldkirchen in Kärnten (AT)**

(72) Erfinder:
• **PÖTZI, Peter
8010 Graz (AT)**
• **MARCHER, Ruben
8010 Graz (AT)**

(74) Vertreter: **Weiser Voith Gugler
Patentanwälte Partnerschaft
Kopfgasse 7
1130 Wien (AT)**

(54) **MESSVORRICHTUNG UND VERFAHREN ZUM BERÜHRUNGSLOSEN ERMITTELN EINER ELEKTRISCHEN STROMSTÄRKE**

(57) Die vorliegende Erfindung betrifft eine Messvorrichtung (1) zum berührungslosen Ermitteln der elektrischen Stromstärke (I) eines stromdurchflossenen Leiters (2), umfassend ein Trägerelement (3), einen ersten und einen zweiten am Trägerelement (3) montierten Hallsensor ($S_1$, $S_2$) zum Erfassen eines den stromdurchflossenen Leiter (2) umgebenden Magnetfelds, und einen mit dem ersten und dem zweiten Hallsensor ($S_1$, $S_2$) verbundenen Prozessor (4) zum Ermitteln der Stromstärke (I) mithilfe des erfassten Magnetfelds. Die Erfindung betrifft ferner ein Verfahren (12) zum berührungslosen Ermitteln der elektrischen Stromstärke (I) eines stromdurchflossenen Leiters (2).

*Fig. 1*

## Beschreibung

Die vorliegende Erfindung betrifft eine Messvorrichtung zum berührungslosen Ermitteln der elektrischen Stromstärke eines stromdurchflossenen Leiters, umfassend ein Trägerelement, einen ersten und einen zweiten am Trägerelement montierten Hallsensor zum Erfassen eines den stromdurchflossenen Leiter umgebenden Magnetfelds, und einen mit dem ersten und dem zweiten Hallsensor verbundenen Prozessor zum Ermitteln der Stromstärke mithilfe des erfassten Magnetfelds. Die Erfindung betrifft ferner ein Verfahren zum berührungslosen Ermitteln der Stromstärke unter Verwendung der genannten Messvorrichtung.

Die elektrische Stromstärke in einem stromdurchflossenen Leiter kann einerseits direkt gemessen werden, indem ein Strommessgerät in die elektrische Leitung geschaltet, d.h. damit galvanisch verbunden, wird. Solche direkte Messungen werden in Anwendungen vorgesehen, bei welchen die elektrische Stromstärke durchgängig oder sehr häufig erfasst werden soll, da das Strommessgerät im Allgemeinen fix verbaut werden muss. Soll hingegen die elektrische Stromstärke nur einmalig oder selten gemessen werden, z.B. um einen Fehler in einem elektrischen System zu detektieren oder einen Augenblicksverbrauch zu erfassen, dann sind andererseits indirekte Messungen z.B. mithilfe einer - meist tragbaren - Stromzange (auch: "Zangenamperemeter") zweckmäßig, die potentialfrei und im Allgemeinen berührungslos sind. Eine solche Stromzange hat einen Handgriff, der üblicherweise den Messteil und eine Anzeige umfasst, und einen vom Handgriff abstehenden zangenförmigen Greifer, der mit einem Griff geöffnet, um den elektrischen Leiter gelegt und - meist federgespannt - geschlossen werden kann, sodass der zu messende elektrische Leiter vollständig umgriffen ist. Im Inneren des Greifers ist ein elektrisch bzw. magnetisch leitender Ringkern, der beim Schließen an dieser Stelle der Zange ebenfalls geschlossen wird. Bei einer Stromzange zum Messen von Wechselstrom, ist der Ringkern im Inneren des Greifers vorrangig elektrisch leitend und trägt an seiner Handgriffseite mehrere Wicklungen einer Spule, welche den von der elektrischen Leitung in den Ringkern induzierten elektrischen Strom abnimmt, um daraus im Messteil die elektrische Stromstärke im umgriffenen Leiter zu ermitteln. In einer alternativen Ausführungsform ist der Ringkern vorrangig magnetisch leitend und an seiner Handgriffseite durch einen radialen Querschlitz durchtrennt, in welchem quer zur Umlaufrichtung des Ringkerns ein Hallsensor angeordnet ist, der den von der elektrischen Leitung in den Ringkern induzierten magnetischen Fluss erfasst, woraus die elektrische Stromstärke im Leiter ermittelt wird. Dadurch können auch Gleichanteile der elektrischen Stromstärke erfasst werden.

Derartige Strommesszangen sind einfach in der Handhabung und recht präzise im Messergebnis, jedoch sind nicht alle elektrischen Leiter auch entsprechend rundum zugänglich, dass sie vom Greifer vollständig umgriffen werden können. Überdies ist der Leiterquerschnitt durch den Innendurchmesser des Greifers beschränkt. Lässt sich der Greifer nicht vollständig schließen, ist das Messergebnis unbrauchbar. Daher sind Alternativen bekannt:
Beispielsweise ist aus der DE 10 2005 013 232 A1 bekannt, mehrere Hallsensoren an einem ringförmigen, einen Leiter umschließenden Trägerelement ohne Ringkern anzubringen. Das Trägerelement wird fix um den Leiter herum montiert, wodurch die Hallsensoren einen bekannten Abstand vom Leiter haben. Eine solche Messvorrichtung ist daher weder flexibel einsetzbar noch tragbar.

Alternativ dazu offenbart die US 7 719 258 B2 eine Messvorrichtung, bei welcher je zwei Hallsensoren paarweise und einander gegenüberliegend quer zu Umfangsrichtung des Leiters an diesem angebracht werden. Ein solches Anbringen der Hallsensoren am Leiter ist allerdings aufwändig und erfordert einen zumindest weitgehend freiliegenden Leiter. Überdies besteht erhöhte Gefahr einer Berührung des Leiters beim Anbringen der Hallsensoren. Schließlich muss der Leiterquerschnitt bekannt sein, um die elektrische Stromstärke ermitteln zu können.

Die Erfindung setzt sich zum Ziel, eine Messvorrichtung zum berührungslosen Ermitteln der elektrischen Stromstärke zu schaffen, welche besonders einfach handhabbar ist und die Stromstärke des Leiters präzise ermitteln lässt, ohne die Lage der Hallsensoren zum Leiter bzw. den Leiterquerschnitt vorzugeben.

Dieses Ziel wird gemäß einem ersten Aspekt mit einer Messvorrichtung der einleitend genannten Art erreicht, welche sich erfindungsgemäß dadurch auszeichnet, dass der erste Hallsensor dazu ausgebildet ist, einen ersten Flussdichtevektor des Magnetfelds dreidimensional zu erfassen, und der zweite Hallsensor in einem bekannten Relativabstand vom ersten Hallsensor am Trägerelement montiert und dazu ausgebildet ist, einen zweiten Flussdichtevektor des Magnetfelds dreidimensional zu erfassen, wobei der Prozessor dazu ausgebildet ist, einen ersten Normalabstand zwischen dem Leiter und dem ersten Hallsensor mithilfe des Relativabstands und des erfassten ersten und des erfassten zweiten Flussdichtevektors geometrisch zu berechnen, und die Stromstärke mithilfe des berechneten ersten Normalabstands und des Betrags des erfassten ersten Flussdichtevektors zu ermitteln.

Durch einfaches in die Nähe des Leiters Bringen der erfindungsgemäßen Messvorrichtung, z.B. durch Nahehalten oder Anlegen, kann mithilfe der geometrischen Berechnung der erste Normalabstand vom Leiterzentrum berechnet werden. Die geometrische Berechnung beruht auf der dreidimensionalen Erfassung der beiden Flussdichtevektoren, d.h. deren jeweiligen Ausrichtung und Länge im 3D-Raum. Mit diesen kann im Zusammenwirken mit dem bekannten Relativabstand der beiden Hallsensoren der Normalabstand zumindest eines der Hallsensoren gegenüber dem Leiter und daraus und aus dem Betrag des Flussdichtevektors die Stromstärke nach dem bekannten Biot-Savart-Gesetz einfach und präzise ermittelt werden. Vorabkenntnis über die genaue Ausrichtung, Position oder den Querschnitt des Leiters, oder das Einhalten spezieller Lageerfordernisse der Messvorrichtung gegenüber dem Leiter sind nicht erforderlich. Komplizierte, raumgreifende Montageschritte, um die Hallsensoren in vordefinierten Abständen zum Leiter zu montieren, oder ein Freilegen des Leiters zum Umgreifen mit einer Stromzange entfallen.

In einer vorteilhaften Ausführungsform ist der Prozessor dazu ausgebildet, ferner einen zweiten Normalabstand zwischen dem Leiter und dem zweiten Hallsensor mithilfe des Relativabstands und des erfassten ersten und des erfassten zweiten Flussdichtevektors geometrisch zu berechnen, und die Stromstärke als Mittelwert aus einem ersten und einem zweiten Stromwert zu ermitteln, wobei der Prozessor den ersten Stromwert mithilfe des berechneten ersten Normalabstands und des Betrags des erfassten ersten Flussdichtevektors und den zweiten Stromwert mithilfe des ermittelten zweiten Normalabstandes und der erfassten zweiten Flussdichte errechnet. Durch die Mittelung der beiden Stromwerte wird die Messgenauigkeit der Messvorrichtung erhöht. Ferner kann mithilfe der beiden Normalabstände die genaue Lage des Leiters bestimmt werden.

Besonders günstig ist, wenn die Messvorrichtung ferner für jeden Hallsensor ein daran angeschlossenes High-Pass-Filter aufweist. Das High-Pass-Filter filtert statische und niederfrequente Störfelder aus, die das Magnetfeld überlagern, z.B. das Erdmagnetfeld, was die Messgenauigkeit erhöht.

Bevorzugt weist die Messvorrichtung ferner eine mit dem Prozessor verbundene Antenne zum Erfassen eines zeitlichen Verlaufs einer Feldstärke eines den stromdurchflossenen Leiter umgebenden elektrischen Feldes auf, und der Prozessor ist ferner dazu ausgebildet, einen zeitlichen Verlauf der ermittelten Stromstärke zu berechnen und aus einer Phasendifferenz zwischen dem berechneten zeitlichen Verlauf der Stromstärke und dem erfassten zeitlichen Verlauf der elektrischen Feldstärke einen Wirkleistungsfaktor zu ermitteln. Damit kann in einem Messzeitraum nicht nur die Stromstärke sondern auf einfache Weise zugleich der Wirkleistungsfaktor der mit dem Leiter verbundenen elektrischen Verbraucher im Wechselstrom ermittelt werden. Unabhängig von der Ermittlung des Wirkleistungsfaktors kann der ermittelte zeitliche Verlauf der elektrischen Feldstärke zur Identifizierung der Phase des stromdurchflossenen Leiters genutzt werden, wenn mehrere Leiter verschiedener Phasen unterschieden werden sollen.

Das Trägerelement kann jede beliebige Form haben, besonders vorteilhaft ist allerdings, wenn das Trägerelement eine Seite mit einer Einbuchtung zwischen dem ersten und dem zweiten Hallsensor hat. Die Beträge der beiden Flussdichtevektoren verhalten sich indirekt proportional zum jeweiligen Normalabstand. Durch die Einbuchtung kann die Messvorrichtung näher an den Leiter gebracht, wodurch sich die beiden Normalabstände verkürzen und die Beträge der beiden Flussdichtevektoren vergrößern. Dadurch vergrößert sich der Bereich der messbaren Stromstärke und im Allgemeinen auch die Messgenauigkeit, insbesondere für kleine Stromstärke.

In einer vorteilhaften ersten Variante ist der Prozessor dazu ausgebildet, den ersten Normalabstand gemäß

$$r_1 = \frac{d \cdot \sin\left(90 - \arccos\left(\frac{B_2 \circ v_d}{|B_2| \cdot d}\right)\right)}{\sin\left(\arccos\left(\frac{B_1 \circ v_d}{|B_1| \cdot d}\right) + \arccos\left(\frac{B_2 \circ v_d}{|B_2| \cdot d}\right)\right)} \qquad (1)$$

zu berechnen, mit

| | |
|---|---|
| d | Relativabstand, |
| sin | Sinusfunktion, |
| arccos | Arkuskosinusfunktion, |
| $B_2$ | zweiter Flussdichtevektor des Magnetfelds, |
| $\circ$ | Operator für das Skalarprodukt, |
| $v_d$ | Relativabstandsvektor der Länge des Relativabstands und der Richtung vom ersten zum zweiten Hallsensor, |
| $|B_2|$ | Betrag des zweiten Flussdichtevektors, |
| $B_1$ | erster Flussdichtevektor des Magnetfelds und |
| $|B_1|$ | Betrag des ersten Flussdichtevektors. |

Mithilfe der Gleichung (1) wird der erste Normalabstand mit guter Genauigkeit und mit geringer Prozessorleistung berechnet, insbesondere wenn beide Hallsensoren annähernd in einer gemeinsamen Ebene liegen, die normal auf den Leiter steht. Ein "Verkippen" der Messvorrichtung gegenüber der genannten Ebene bleibt unberücksichtigt, ist aber nur von geringem Einfluss auf das Messergebnis, solange der Kippwinkel gering ist.

In einer vorteilhaften zweiten Variante ist der Prozessor dazu ausgebildet, den ersten Normalabstand gemäß

$$r_1 = \frac{d' \cdot \sin\left(90 - \arccos\left(\frac{B_2 \circ v_d'}{|B_2| \cdot d'}\right)\right)}{\sin\left(\arccos\left(\frac{B_1 \circ v_d'}{|B_1| \cdot d'}\right) + \arccos\left(\frac{B_2 \circ v_d'}{|B_2| \cdot d'}\right)\right)} \qquad (2)$$

zu berechnen, mit

d'  in eine erste Normalebene des Leiters, die den ersten Hallsensor enthält, projizierter Relativabstand, welcher gemäß $d' = \sqrt{d^2 - z^2}$ berechnet wird, wobei d der Relativabstand und z eine in Parallelrichtung zum Leiter gesehene Höhe des zweiten Hallsensors über der ersten Normalebene ist, welche Höhe z gemäß $z = \frac{|v_d \circ (B_1 \times B_2)|}{|B_1 \times B_2|}$ berechnet wird, wobei $v_d$ der Relativabstandsvektor ist,

sin  Sinusfunktion,
arccos  Arkuskosinusfunktion,
$B_2$  zweiter Flussdichtevektor des Magnetfelds,
$\circ$  Operator für das Skalarprodukt,
$v_d'$  in die erste Normalebene projizierter Relativabstandsvektor der Länge des projizierten Relativabstands d' und der Richtung vom ersten Hallsensor zu einem in die erste Normalebene projizierten Fußpunkt des zweiten Hallsensors, welcher projizierter Relativabstandsvektor gemäß $v_d' = v_d + v_z$ berechnet wird, wobei $v_z$ ein Höhenvektor der Länge der Höhe und der Richtung vom zweiten Hallsensor zum Fußpunkt ist, welcher Höhenvektor gemäß $v_z = \frac{B_2 \times B_1}{|B_2 \times B_1|} \cdot z$ berechnet wird,

$\times$  Operator für das Vektorprodukt,
$B_1$  erster Flussdichtevektor des Magnetfelds,
$|B_2|$  Betrag des zweiten Flussdichtevektors und
$|B_1|$  Betrag des ersten Flussdichtevektors.

Gleichung (2) berücksichtigt ein Verkippen der Messvorrichtung gegenüber dem Leiter. Dadurch kann der erste Normalabstand auch dann besonders präzise berechnet werden, wenn beide Hallsensoren in zwei unterschiedlichen Ebenen liegen, die jeweils normal auf den Leiter stehen. Eine Kooperation des Benutzers, d.h. sein möglichst wenig verkipptes Halten der Messvorrichtung gegenüber dem Leiter, ist in diesem Fall für ein präzises Messergebnis nicht erforderlich.

In einer weiteren günstigen Ausführungsform umfasst die Messvorrichtung ferner eine optische Anzeige zum Anzeigen der ermittelten Stromstärke. Damit kann die Stromstärke vom Benutzer direkt an der Messvorrichtung ausgelesen werden.

In einem zweiten Aspekt der Erfindung wird ein Verfahren der eingangs genannten Art bereitgestellt, welches umfasst:

dreidimensionales Erfassen eines ersten Flussdichtevektors eines den stromdurchflossenen Leiter umgebenden Magnetfelds mit einem ersten Hallsensor und eines zweiten Flussdichtevektors des Magnetfelds mit einem zweiten in einem bekannten Relativabstand vom ersten Hallsensor an einem Trägerelement montierten Hallsensor;
in einem mit dem ersten und dem zweiten Hallsensor verbundenen Prozessor, geometrisches Berechnen eines ersten Normalabstands zwischen dem Leiter und dem ersten Hallsensor mithilfe des Relativabstands und des erfassten ersten und des erfassten
zweiten Flussdichtevektors; und Ermitteln der Stromstärke mithilfe des berechneten ersten Normalabstands und des Betrags des erfassten ersten Flussdichtevektors.

Hinsichtlich der Vorteile und vorteilhafter Ausführungsformen des erfindungsgemäßen Verfahrens wird auf die obigen Ausführungen zur erfindungsgemäßen Vorrichtung verwiesen.

Die Erfindung wird nachstehend anhand von in den beigeschlossenen Zeichnungen dargestellten Ausführungsbeispielen näher erläutert. In den Zeichnungen zeigen:

Fig. 1 eine erste Ausführungsform einer Messvorrichtung zum berührungslosen Ermitteln der elektrischen Stromstärke eines stromdurchflossenen Leiters, in einer schematischen Draufsicht;

die Fig. 2 bis 4 Beispiele für von der Messvorrichtung aus Fig. 1 erfasste magnetische Flussdichtevektoren um den Leiter, in einer Draufsicht (Fig. 2) und in einer jeweiligen Schrägansicht (Fig. 3 und 4); und

Fig. 5 ein erfindungsgemäßes Verfahren zum berührungslosen Ermitteln der Stromstärke in einem Flussdiagramm.

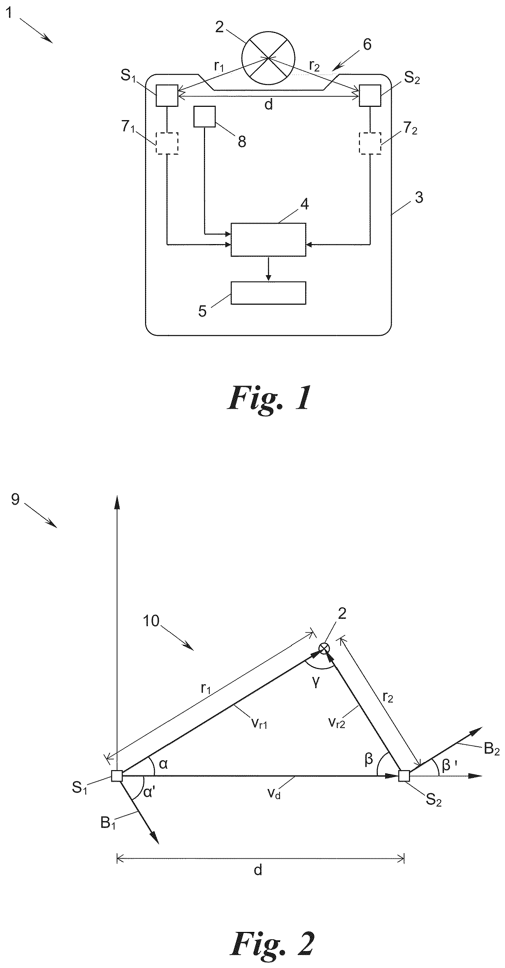

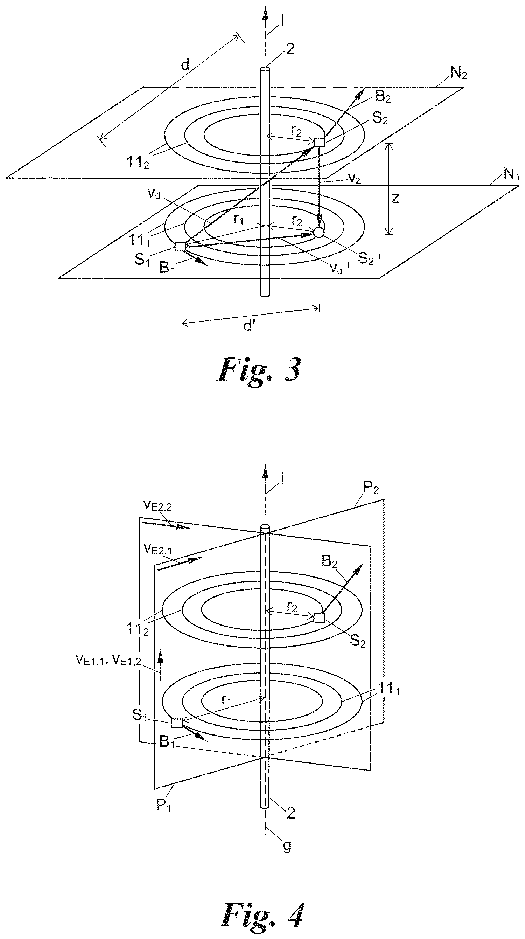

Fig. 1 zeigt eine Messvorrichtung 1 zum berührungslosen Ermitteln der elektrischen Stromstärke I (Fig. 3) eines stromdurchflossenen Leiters 2. Der Leiter 2 ist beispielsweise eine von Wechselstrom oder Gleichstrom durchflossene Ader eines Kabels, Stromschiene, Litze einer Litzenleitung od.dgl.

Die Messvorrichtung 1 umfasst ein Trägerelement 3, z.B. eine Leiterplatte od.dgl., und einen ersten und einen zweiten Hallsensor $S_1$, $S_2$. Der erste und der zweite Hallsensor $S_1$, $S_2$ sind am Trägerelement 3 in einem bekannten Relativabstand d voneinander montiert und erfassen ein Magnetfeld (nicht gezeigt), das den stromdurchflossenen Leiter 2 umgibt, wie weiter unten unter Bezugnahme auf die Fig. 2 bis 4 näher ausgeführt wird.

Im Beispiel der Fig. 1, ist das Trägerelement 3 in Draufsicht rechteckig mit abgerundeten Ecken, und der erste und der zweite Hallsensor $S_1$, $S_2$ sind optional nahe zweier benachbarter Ecken montiert. Alternativ könnte das Trägerelement in Draufsicht z.B. dreieckig oder Y-förmig sein oder eine beliebige andere Form haben und/oder die Hallsensoren $S_1$, $S_2$ an anderer Stelle montiert sein.

Die Messvorrichtung 1 umfasst ferner einen Prozessor 4, der mit dem ersten und dem zweiten Hallsensor $S_1$, $S_2$ verbunden ist und die Stromstärke I mithilfe des erfassten Magnetfelds ermittelt, wie in weiter Folge erläutert wird. Optional umfasst die Messvorrichtung 1 eine an dem Prozessor 4 angeschlossene optische Anzeige 5, z.B. ein LCD oder LED display, zum Anzeigen der ermittelten Stromstärke I.

Anhand der Beispiele der beiden Fig. 1 und 2 soll das Prinzip des Ermittelns der elektrischen Stromstärke I durch die Messvorrichtung 1 in einfacher Weise erläutert werden:

Der erste und der zweite Hallsensor $S_1$, $S_2$ sind jeweils dreidimensionale ("3D"-) Hallsensoren $S_1$, $S_2$, sodass der erste Hallsensor $S_1$ einen ersten Flussdichtevektor $B_1$ und der zweite Hallsensor $S_2$ einen zweiten Flussdichtevektor $B_2$ des den Leiter 2 umgebenden Magnetfelds jeweils dreidimensional erfasst, u.zw. indem jeder Hallsensor $S_1$, $S_2$ für jede der drei Raumrichtungen jeweils eine entsprechende Hallspannung misst und daraus den jeweiligen Flussdichtevektor $B_1$ bzw. $B_2$ berechnet. Der Prozessor 4 berechnet einen ersten Normalabstand $r_1$, d.h. den kürzesten Abstand, zwischen dem Leiter 2 - genaugenommen dem Zentrum des Leiters 2 wie in Fig. 1 gezeigt - und dem ersten Hallsensor $S_1$ mithilfe des Relativabstands d und des erfassten ersten und des erfassten zweiten Flussdichtevektors $B_1$, $B_2$ auf geometrische Weise, wie weiter unten unter Bezugnahme auf die Fig. 2 bis 4 in verschiedenen Variationen näher erläutert wird. Mithilfe des berechneten ersten Normalabstands $r_1$ und des Betrags des erfassten ersten Flussdichtevektors $B_1$ ermittelt der Prozessor 4 darauf nach dem bekannten Biot-Savart-Gesetz die Stromstärke I. Der Prozessor 4 ist entweder eine Hardware-Schaltung, z.B. ein ASIC, FPGA, etc., oder eine programmierbare CPU mit entsprechendem Programm für die Berechnungen und Ermittlungen.

Es versteht sich, dass die Messvorrichtung 1 mit jener Seite, an welcher die Hallsensoren $S_1$, $S_2$ montiert sind, an den Leiter 2 angelegt oder davon beabstandet (hier: beabstandet) gehalten werden kann. Optional hat das Trägerelement 3 an dieser Seite eine Einbuchtung 6 zwischen dem ersten und dem zweiten Hallsensor $S_1$, $S_2$, sodass die beiden Hallsensoren $S_1$, $S_2$ näher an den Leiter 2 gebracht werden können. Die Einbuchtung 6 soll dabei derart geformt sein, dass ihre Tiefe jedenfalls weniger als die Hälfte des Durchmessers jedes zu vermessenden Leiters 2 beträgt.

In einer optionalen Ausführungsform berechnet der Prozessor 4 nicht nur den ersten Normalabstand $r_1$ sondern auch den zweiten Normalabstand $r_2$ zwischen dem Leiter 2 und dem zweiten Hallsensor $S_2$ auf geometrische Weise. In diesem Fall errechnet der Prozessor 4 ferner mithilfe des berechneten ersten Normalabstands $r_1$ und des Betrags des ersten Flussdichtevektors $B_1$ einen ersten Stromwert und mithilfe des zweiten Normalabstands $r_2$ und dem zweiten Flussdichtevektors $B_2$ einen zweiten Stromwert gemäß Biot-Savart-Gesetz. Schließlich ermittelt der Prozessor 4 die Stromstärke I als Mittelwert aus dem errechneten ersten und zweiten Stromwert.

Um von statischen Magnetfeldern, z.B. dem Erdmagnetfeld, oder niederfrequenten Magnetfeldern nicht gestört zu werden, kann die Messvorrichtung 1 optional für jeden Hallsensor $S_1$, $S_2$ ein High-Pass-Filter $7_1$, $7_2$ aufweisen.

Die Messvorrichtung 1 des Beispiels der Fig. 1 weist ferner eine z.B. auf dem Trägerelement 3 montierte, mit dem Prozessor 4 verbundene optionale Antenne 8 auf. Die Antenne 8 erfasst einen zeitlichen Verlauf der elektrischen Feldstärke des den Leiter 2 umgebenden elektrischen Feldes (nicht gezeigt) und gibt diese an den Prozessor 4 aus. In dieser Ausführungsvariante berechnet der Prozessor 4 ferner einen zeitlichen Verlauf der Stromstärke I und aus der Phasendifferenz zwischen den zeitlichen Verläufen der elektrischen Feldstärke und der Stromstärke I einen Wirkleistungsfaktor $\lambda = \cos(\varphi)$ (mit der Phasendifferenz $\varphi$) der an den Leiter 2 angeschlossenen elektrischen Verbraucher. Zusätzlich oder alternativ zum Berechnen des Wirkleistungsfaktors ist der Prozessor 4 optional dazu ausgebildet, den ermittelten zeitlichen Verlauf der elektrischen Feldstärke z.B. zur Identifizierung der Phase des stromdurchflossenen Leiters 2 zu nutzen, um diesen Leiter 2 von anderen Leitern anderer Phasen zu unterscheiden.

Anhand der Fig. 2 bis 4 werden im Folgenden drei mögliche Varianten der geometrischen Berechnung des ersten Normalabstands $r_1$ erläutert.

In einer ersten, einfacheren Variante wird gemäß Fig. 2 angenommen, dass der erste und zweite Hallsensor $S_1$, $S_2$ in ein und derselben zum Leiter 2 normalen Ebene liegen. Dabei wird ein mögliches Verkippen des Trägerelements 3 gegenüber dieser Ebene vereinfachend außer Acht gelassen, was bei geringem Kippwinkel eine gute Näherung erzielt. Fig. 2 zeigt die der ersten Variante zugrundliegenden geometrischen Verhältnisse in einem Koordinatensystem 9, worin der erste und zweite Hallsensor $S_1$, $S_2$ mit dem Leiter 2 gemeinsam ein Dreieck 10 aufspannen. Zwei Seiten des Dreiecks 10 werden durch einen ersten und zweiten Normalabstandsvektor $vr_1$, $vr_2$ jeweils vom ersten und zweiten Hallsensor $S_1$, $S_2$ zum Leiter 2 gebildet und die dritte Dreiecksseite durch einen Relativabstandsvektor $v_d$ vom ersten Hallsensor $S_1$ zum zweiten Hallsensor $S_2$. Der Betrag des Relativabstandsvektors $v_d$ entspricht dem Relativabstand d und die Beträge der Normalabstandsvektoren $vr_1$, $vr_2$ entsprechen den jeweiligen Normalabständen $r_1$, $r_2$.

Der erste und zweite Flussdichtevektor $B_1$, $B_2$ haben ihren Ursprung im entsprechenden ersten und zweiten Hallsensor $S_1$, $S_2$ und stehen aufgrund der Geometrie des Magnetfelds, welches den Leiter 2 konzentrisch umgibt, normal auf den jeweiligen Normalabstandsvektor $vr_1$, $vr_2$.

In dieser Variante berechnet der Prozessor 4 zunächst einen ersten und zweiten Außenwinkel α', β' mithilfe des Kosinussatzes und der Vektorbeziehung zwischen dem Relativabstandsvektor $v_d$ und jeweils dem ersten und zweiten Flussdichtevektor $B_1$, $B_2$, beispielsweise gemäß

$$\alpha' = \arccos\left( \frac{B_1 \circ v_d}{|B_1| \cdot d} \right) \qquad (3)$$

und

$$\beta' = \arccos\left( \frac{B_2 \circ v_d}{|B_2| \cdot d} \right) \qquad (4)$$

mit

arccos     Arkuskosinusfunktion,
∘     Operator für das Skalarprodukt,
$|B_1|$     Betrag des ersten Flussdichtevektors $B_1$ und
$|B_2|$     Betrag des zweiten Flussdichtevektors $B_2$.

Der erste und zweite Außenwinkel α', β' sind jeweils zu den interessierenden ersten und zweiten Innenwinkeln α, β des Dreiecks 10, welche von dem Relativabstandsvektor $v_d$ und dem jeweiligen Normalabstandsvektoren $vr_1$, $vr_2$ eingeschlossen werden, komplementär und können daher gemäß α = 90° - α' und β = 90° - β' berechnet werden.

Ein dritter Innenwinkel γ des Dreiecks 10 kann aus der Innenwinkelsumme für Dreiecke gemäß γ = 180° - α - β berechnet werden. Schließlich berechnet der Prozessor 4 aus dem dritten Innenwinkel γ, dem Relativabstand d, dem zweiten Innenwinkel β und deren Verhältnis zueinander nach dem Sinussatz den ersten Normalabstand $r_1$.

Diese erste Variante der geometrischen Berechnung des ersten Normalabstands $r_1$ kann folglich als Gleichung (5) zusammengefasst und der erste Normalabstand $r_1$ gemäß

$$r_1 = \frac{d \cdot \sin\left( 90 - \arccos\left( \frac{B_2 \circ v_d}{|B_2| \cdot d} \right) \right)}{\sin\left( \arccos\left( \frac{B_1 \circ v_d}{|B_1| \cdot d} \right) + \arccos\left( \frac{B_2 \circ v_d}{|B_2| \cdot d} \right) \right)} \qquad (5)$$

berechnet werden, mit

sin     Sinusfunktion,
arccos     Arkuskosinusfunktion,

∘ Operator für das Skalarprodukt,

$|B_2|$ Betrag des zweiten Flussdichtevektors $B_2$ und

$|B_1|$ Betrag des ersten Flussdichtevektors $B_1$.

Wie weiter oben erläutert berechnet der Prozessor 4 optional zusätzlich den zweiten Normalabstand $r_2$, u.zw. in der ersten Variante z.B. mit dem dritten Innenwinkel $\gamma$, dem Relativabstand d, dem ersten Innenwinkel $\alpha$ und deren Verhältnis zueinander wieder nach dem Sinussatz, z.B. gemäß der folgenden Gleichung (6)

$$r_2 = \frac{d \cdot \sin\left(90 - \arccos\left(\frac{B_1 \circ v_d}{|B_1| \cdot d}\right)\right)}{\sin\left(\arccos\left(\frac{B_1 \circ v_d}{|B_1| \cdot d}\right) + \arccos\left(\frac{B_2 \circ v_d}{|B_2| \cdot d}\right)\right)} \qquad (6)$$

mit

sin  Sinusfunktion,

arccos  Arkuskosinusfunktion,

∘ Operator für das Skalarprodukt,

$|B_1|$ Betrag des ersten Flussdichtevektors $B_1$ und

$|B_2|$ Betrag des zweiten Flussdichtevektors $B_2$.

Im Beispiel der Fig. 3 wird eine zweite präzisere Variante der geometrischen Berechnung veranschaulicht: In diesem Beispiel liegen der erste und zweite Hallsensor $S_1$, $S_2$ in zwei unterschiedlichen Normalebenen $N_1$, $N_2$ des Leiters 2, d.h. die Messvorrichtung 1 ist gegenüber dem Leiter 2 verkippt. Der erste Hallsensor $S_1$ erfasst den ersten Fluss-dichtevektor $B_1$ in der (unteren) ersten Normalebene $N_1$ der (unteren) Feldlinien $11_1$ des Magnetfelds und der zweite Hallsensor $S_2$ den zweiten Flussdichtevektor $B_2$ in der (oberen) zweiten Normalebene $N_2$ der (oberen) Feldlinien $11_2$.

Die zweite Normalebene $N_2$ liegt in Parallelrichtung zum Leiter 2 gesehen in einer Höhe z über der ersten Normalebene $N_1$. Bei solcher Anordnung ist der bekannte Relativabstand d zwischen den beiden Hallsensoren $S_1$, $S_2$ größer als ein projizierter Relativabstand d', welcher gemäß den Gleichungen (5) bzw. (6) zugrunde zu legen wäre. Um den projizierten Relativabstand d' zu berechnen, wird der zweite Hallsensor $S_2$ auf die Normalebene $N_1$ des ersten Hallsensors $S_1$ projiziert, wie in Fig. 3 durch einen projizierten Fußpunkt $S_2'$ des zweiten Hallsensors $S_2$ in die (untere) erste Normalebene $N_1$ des ersten Hallsensors $S_1$ abgebildet ist. Die Distanz zwischen dem zweiten Hallsensor $S_2$ und seinem Fußpunkt $S_2'$ ist die Höhe z, welche analog zur Berechnung des Abstands zweier windschiefer Geraden (hier: der beiden Flussdichtevektoren $B_1$, $B_2$) beispielsweise gemäß

$$z = \frac{|v_d \circ (B_1 \times B_2)|}{|B_1 \times B_2|} \qquad (7)$$

ermittelt werden kann, mit

∘ Operator für das Skalarprodukt und

× Operator für das Vektorprodukt.

Aus der berechneten Höhe z und dem Relativabstand d kann der projizierte Relativabstand d' z.B. gemäß dem Pythagoras-Satz bestimmt werden.

Mithilfe der Höhe z und dem ersten und zweiten Flussdichtevektor $B_1$, $B_2$ kann ferner ein Höhenvektor $v_z$ der Länge der Höhe z und der Richtung vom zweiten Hallsensor $S_2$ zum Fußpunkt $S_2'$ gemäß

$$v_z = \frac{B_2 \times B_1}{|B_2 \times B_1|} \cdot z \qquad (8)$$

berechnet werden, mit

×   Operator für das Vektorprodukt.

Durch Bilden einer Vektorsumme aus dem Höhenvektor $v_z$ und dem Relativabstandsvektor $v_d$ kann ein projizierter Relativabstandsvektor $v_d'$, welcher die Länge des projizierten Relativabstands d' und die Richtung vom ersten Hallsensor $S_1$ zum Fußpunkt $S_2'$ hat, bestimmt werden.

Wird der Relativabstand d durch den projizierten Relativabstand d' und der Relativabstandsvektor $v_d$ durch den projizierten Relativabstandsvektor $v_d'$ in den Gleichungen (5) und (6) ersetzt, kann eine Verkippung der Messvorrichtung 1 gegenüber dem Leiter 2 berücksichtigt werden und der erste Normalabstand $r_1$ gemäß

$$r_1 = \frac{d' \cdot \sin\left(90 - \arccos\left(\frac{B_2 \circ v_d'}{|B_2| \cdot d'}\right)\right)}{\sin\left(\arccos\left(\frac{B_1 \circ v_d'}{|B_1| \cdot d'}\right) + \arccos\left(\frac{B_2 \circ v_d'}{|B_2| \cdot d'}\right)\right)} \qquad (9)$$

sowie optional zusätzlich der zweite Normalabstand $r_2$ gemäß

$$r_2 = \frac{d' \cdot \sin\left(90 - \arccos\left(\frac{B_1 \circ v_d'}{|B_1| \cdot d'}\right)\right)}{\sin\left(\arccos\left(\frac{B_1 \circ v_d'}{|B_1| \cdot d'}\right) + \arccos\left(\frac{B_2 \circ v_d'}{|B_2| \cdot d'}\right)\right)} \qquad (10)$$

berechnet werden, mit

sin         Sinusfunktion,
arccos      Arkuskosinusfunktion,
∘           Operator für das Skalarprodukt,
$|B_2|$     Betrag des zweiten Flussdichtevektors $B_2$ und
$|B_1|$     Betrag des ersten Flussdichtevektors $B_1$.

Fig. 4 zeigt wie Fig. 3 den ersten und zweiten Hallsensor $S_1$, $S_2$ in zwei unterschiedlichen Normalebenen (hier nicht dargestellt) zum Leiter 2. In einer dritten Variante der geometrischen Berechnung wird der erste und optional der zweite Normalabstand $r_1$, $r_2$ mithilfe von den Leiter 2 enthaltenden Parallelebenen $P_1$, $P_2$ ermittelt: eine erste Parallelebene $P_1$, in welcher der erste Hallsensor $S_1$ liegt, und eine zweite Parallelebene $P_2$, in welcher der zweite Hallsensor $S_2$ liegt. Die beiden Parallelebenen $P_1$, $P_2$ werden beispielsweise durch jeweils zwei Parallelebenenvektoren $v_{E1,1}$ bzw. $v_{E1,2}$ und $v_{E2,1}$ bzw. $v_{E2,2}$ und einen Punkt, z.B. $S_1$ bzw. $S_2$, die allesamt in den jeweiligen Parallelebenen $P_1$, $P_2$ liegen, beschrieben. Da die beiden Parallelebenen $P_1$, $P_2$ einander schneiden, können die ersten Parallelebenenvektoren $v_{E1,1}$, $v_{E1,2}$ in beiden Parallelebenen $P_1$, $P_2$ gleich bzw. zueinander parallel sein. Sie ergeben sich beispielsweise aufgrund der Geometrie des den Leiter 2 konzentrisch umgebenden Magnetfelds für beide Parallelebenen $P_1$, $P_2$ als Kreuzprodukt des ersten und zweiten Flussdichtevektors $B_1$, $B_2$ und können gemäß $v_{E1,1} = v_{E1,2} = B_1 \times B_2$ errechnet werden. Da ferner der erste und zweite Flussdichtevektor $B_1$, $B_2$ jeweils normal auf die erste und zweite Parallelebene $P_1$, $P_2$ stehen, können jeweils die zweiten Parallelebenenvektoren $v_{E2,1}$, $v_{E2,2}$ für die erste Parallelebene $P_1$ als Kreuzprodukt gemäß $v_{E2,1} = B_1 \times (B_1 \times B_2)$ und für die zweite Parallelebene $P_2$ als Kreuzprodukt gemäß $v_{E2,2} = B_2 \times (B_1 \times B_2)$ errechnet werden.

Die Schnittgerade g der ersten und zweiten Parallelebene $P_1$, $P_2$ ergibt sich durch Schneiden der beiden Parallelebenen $P_1$, $P_2$, z.B. durch ineinander Einsetzen in ihre Ebenengleichungen; sie liegt im Zentrum des Leiters 2. Erster und zweiter Normalabstand $r_1$, $r_2$ des ersten und zweiten Hallsensors $S_1$, $S_2$ von der Schnittgeraden g können dann gemäß

$$r_1 = \frac{|(B_1 \times v_g) \circ (G_1 - S_1)|}{|B_1 \times v_g|} \qquad (11)$$

bzw.

$$r_2 = \frac{\left|(B_2 \times v_g) \circ (G_1 - S_2)\right|}{\left|B_2 \times v_g\right|} \qquad (12)$$

berechnet werden, mit

$\times$     Operator für das Vektorprodukt,

$v_g$     Geradenvektor der Schnittgeraden g, wobei die Schnittgerade als $g : G_1 + k \cdot v_g$ erzeugt wird, worin k eine Variable und $G_1$ ein beliebiger Punkt auf der Schnittgeraden g ist,

$\circ$     Operator für das Skalarprodukt,

$S_1$     Ort des ersten Hallsensors $S_1$ im Raum und

$S_2$     Ort des zweiten Hallsensors $S_2$ im Raum.

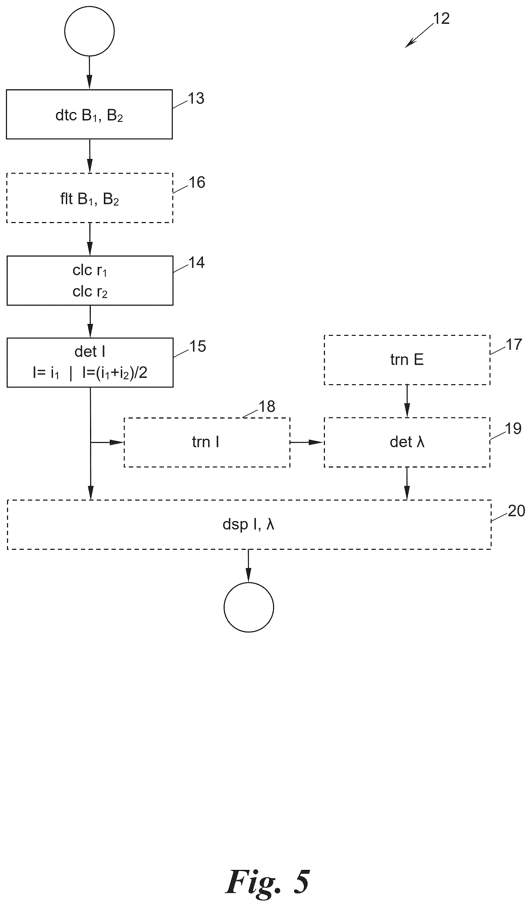

In der Messvorrichtung 1 kann ein in Fig. 5 dargestelltes Verfahren 12 zum berührungslosen Ermitteln der elektrischen Stromstärke I des Leiters 2 ablaufen:
In einem ersten Schritt 13 des Verfahrens 12 erfasst der erste Hallsensor $S_1$ den ersten Flussdichtevektor $B_1$ und der zweite Hallsensor $S_2$ den zweiten Flussdichtevektor $B_2$ des den Leiter 2 umgebenden Magnetfelds jeweils dreidimensional.

In einem zweiten Schritt 14 des Verfahrens 12 berechnet der Prozessor 4 geometrisch den ersten Normalabstand $r_1$ zwischen dem Leiter 2 und dem ersten Hallsensor $S_1$ und optional zusätzlich den zweiten Normalabstand $r_2$ zwischen dem Leiter 2 und dem zweiten Hallsensor $S_2$ mithilfe des bekannten Relativabstands d zwischen dem ersten und zweiten Hallsensor $S_1$, $S_2$ und den in Schritt 13 erfassten Flussdichtevektoren $B_1$, $B_2$. In Bezug auf Details der geometrischen Berechnung wird auf die obigen Ausführungen zu den Fig. 2 bis 4 verwiesen.

In einem dritten Schritt 15 des Verfahrens 12 ermittelt der Prozessor 4 die Stromstärke I mithilfe des berechneten ersten Normalabstands $r_1$ und des Betrags des erfassten ersten Flussdichtevektors $B_1$. Dazu errechnet der Prozessor 4 mithilfe des berechneten ersten Normalabstands $r_1$ und des Betrags des erfassten ersten Flussdichtevektors $B_1$ den ersten Stromwert (im Flussdiagramm der Fig. 5: "$i_1$"), welcher im Fall, dass in Schritt 14 lediglich der erste Normalabstand $r_1$ berechnet wurde, als der Stromstärke I entsprechend angenommen wird: $I = i_1$.

Wenn in Schritt 14 zusätzlich der zweite Normalabstand $r_2$ berechnet wurde, kann ferner der Prozessor 4 mithilfe des berechneten zweiten Normalabstands $r_2$ und des Betrags des erfassten zweiten Flussdichtevektors $B_2$ den zweiten Stromwert (im Flussdiagramm der Fig. 5: "$i_2$") errechnen, in welchem Fall die Stromstärke I als Mittelwert aus dem ersten und zweiten Stromwert ermittelt wird: $I = (i_1 + i_2)/2$. Varianten zur geometrischen Berechnung der Normalabstände $r_1$, $r_2$ wurden weiter oben unter Bezugnahme auf die Fig. 2 bis 4 näher erläutert.

In einem optionalen Zwischenschritt 16 des Verfahrens 12, der zwischen den genannten ersten und zweiten Schritten 13, 14 ausgeführt wird, wird der vom ersten oder zweiten Hallsensor $S_1$, $S_2$ jeweils erfasste erste und zweite Flussdichtevektor $B_1$, $B_2$ mit dem jeweiligen High-Pass-Filter $7_1$, $7_2$ gefiltert.

In einem optionalen Schritt 17 des Verfahrens 12, erfassen der Prozessor 4 und die damit verbundene Antenne 8 ferner den zeitlichen Verlauf der Feldstärke des den stromdurchflossenen Leiter 2 umgebenden elektrischen Feldes. In diesem Fall berechnet der Prozessor 4 ferner den zeitlichen Verlauf der Stromstärke I in einem Schritt 18 des Verfahrens 12 und ermittelt aus der Phasendifferenz des erfassten zeitlichen Verlaufs der Feldstärke und des berechneten zeitlichen Verlaufs der Stromstärke I in einem Schritt 19 den Wirkleistungsfaktor $\lambda$. Es versteht sich, dass Schritt 18 vor, während oder nach den Schritten 13 bis 17 des Verfahrens 12 ausgeführt werden kann.

Zusätzlich oder alternativ kann der Prozessor 4 optional den ermittelten zeitlichen Verlauf der elektrischen Feldstärke z.B. zur Identifizierung der Phase des stromdurchflossenen Leiters 2 nutzen, um diesen Leiter 2 von anderen Leitern anderer Phasen zu unterscheiden (nicht dargestellt).

In dem optionalen Fall, dass die Messvorrichtung 1 die optische Anzeige 5 umfasst, kann in einem optionalen letzten Schritt 20 des Verfahrens 12 die ermittelte Stromstärke I und/oder der ermittelte Wirkleistungsfaktor $\lambda = \cos(\varphi)$ (mit der Phasendifferenz $\varphi$) über die Anzeige 5 ausgegeben werden.

Die Erfindung ist nicht auf die dargestellten Ausführungsformen beschränkt, sondern umfasst alle Varianten, Modifikationen und deren Kombinationen, die in den Rahmen der angeschlossenen Ansprüche fallen.

**Patentansprüche**

1. Messvorrichtung (1) zum berührungslosen Ermitteln der elektrischen Stromstärke (I) eines stromdurchflossenen Leiters (2), umfassend

ein Trägerelement (3),

einen ersten und einen zweiten am Trägerelement (3) montierten Hallsensor ($S_1$, $S_2$) zum Erfassen eines den stromdurchflossenen Leiter (2) umgebenden Magnetfelds, und

einen mit dem ersten und dem zweiten Hallsensor ($S_1$, $S_2$) verbundenen Prozessor (4) zum Ermitteln der Stromstärke (I) mithilfe des erfassten Magnetfelds,

**dadurch gekennzeichnet, dass**

der erste Hallsensor ($S_1$) dazu ausgebildet ist, einen ersten Flussdichtevektor ($B_1$) des Magnetfelds dreidimensional zu erfassen, und der zweite Hallsensor ($S_2$) in einem bekannten Relativabstand (d) vom ersten Hallsensor ($S_1$) am Trägerelement (3) montiert und dazu ausgebildet ist, einen zweiten Flussdichtevektor ($B_2$) des Magnetfelds dreidimensional zu erfassen, wobei

der Prozessor (4) dazu ausgebildet ist, einen ersten Normalabstand ($r_1$) zwischen dem Leiter (2) und dem ersten Hallsensor ($S_1$) mithilfe des Relativabstands (d) und des erfassten ersten und des erfassten zweiten Flussdichtevektors ($B_1$, $B_2$) geometrisch zu berechnen, und die Stromstärke (I) mithilfe des berechneten ersten Normalabstands ($r_1$) und des Betrags des erfassten ersten Flussdichtevektors ($B_1$) zu ermitteln.

2. Messvorrichtung nach Anspruch 1, **dadurch gekennzeichnet, dass** der Prozessor (4) dazu ausgebildet ist, ferner einen zweiten Normalabstand ($r_2$) zwischen dem Leiter (2) und dem zweiten Hallsensor ($S_2$) mithilfe des Relativabstands (d) und des erfassten ersten und des erfassten zweiten Flussdichtevektors ($B_1$, $B_2$) geometrisch zu berechnen, und die Stromstärke (I) als Mittelwert aus einem ersten und einem zweiten Stromwert zu ermitteln, wobei der Prozessor (4) den ersten Stromwert mithilfe des berechneten ersten Normalabstands ($r_1$) und des Betrags des erfassten ersten Flussdichtevektors ($B_1$) und den zweiten Stromwert mithilfe des ermittelten zweiten Normalabstandes ($r_2$) und der erfassten zweiten Flussdichte ($B_2$) errechnet.

3. Messvorrichtung nach Anspruch 1 oder 2, **dadurch gekennzeichnet, dass** die Messvorrichtung (1) ferner für jeden Hallsensor ($S_1$, $S_2$) ein daran angeschlossenes High-Pass-Filter ($7_1$, $7_2$) aufweist.

4. Messvorrichtung nach einem der Ansprüche 1 bis 3, **dadurch gekennzeichnet, dass** die Messvorrichtung (1) ferner eine mit dem Prozessor (4) verbundene Antenne (8) zum Erfassen eines zeitlichen Verlaufs einer Feldstärke eines den stromdurchflossenen Leiter (2) umgebenden elektrischen Feldes aufweist, und der Prozessor (4) ferner dazu ausgebildet ist, einen zeitlichen Verlauf der ermittelten Stromstärke (I) zu berechnen und aus einer Phasendifferenz zwischen dem berechneten zeitlichen Verlauf der Stromstärke (I) und dem erfassten zeitlichen Verlauf der elektrischen Feldstärke einen Wirkleistungsfaktor zu ermitteln.

5. Messvorrichtung nach einem der Ansprüche 1 bis 4, **dadurch gekennzeichnet, dass** das Trägerelement (3) eine Seite mit einer Einbuchtung (6) zwischen dem ersten und dem zweiten Hallsensor ($S_1$, $S_2$) hat.

6. Messvorrichtung nach einem der Ansprüche 1 bis 5, **dadurch gekennzeichnet, dass** der Prozessor (4) dazu ausgebildet ist, den ersten Normalabstand ($r_1$) gemäß

$$r_1 = \frac{d \cdot \sin\left(90 - \arccos\left(\frac{B_2 \circ v_d}{|B_2| \cdot d}\right)\right)}{\sin\left(\arccos\left(\frac{B_1 \circ v_d}{|B_1| \cdot d}\right) + \arccos\left(\frac{B_2 \circ v_d}{|B_2| \cdot d}\right)\right)}$$

zu berechnen, mit

d Relativabstand (d),

sin Sinusfunktion,

arccos Arkuskosinusfunktion,

$B_2$ zweiter Flussdichtevektor ($B_2$) des Magnetfelds,

∘ Operator für das Skalarprodukt,

$v_d$ Relativabstandsvektor ($v_d$) der Länge des Relativabstands (d) und der Richtung vom ersten zum zweiten Hallsensor ($S_1$, $S_2$),

$|B_2|$ Betrag des zweiten Flussdichtevektors ($B_2$),

$B_1$ erster Flussdichtevektor ($B_1$) des Magnetfelds und

|B$_1$| Betrag des ersten Flussdichtevektors (B$_1$).

7. Messvorrichtung nach einem der Ansprüche 1 bis 6, **dadurch gekennzeichnet, dass** der Prozessor dazu ausgebildet ist, den ersten Normalabstand (r$_1$) gemäß

$$r_1 = \frac{d' \cdot \sin\left(90 - \arccos\left(\frac{B_2 \circ v_d'}{|B_2| \cdot d'}\right)\right)}{\sin\left(\arccos\left(\frac{B_1 \circ v_d'}{|B_1| \cdot d'}\right) + \arccos\left(\frac{B_2 \circ v_d'}{|B_2| \cdot d'}\right)\right)}$$

zu berechnen, mit

d' in eine erste Normalebene (N$_1$) des Leiters (2), die den ersten Hallsensor (S$_1$) enthält, projizierter Relativabstand, welcher gemäß $d' = \sqrt{d^2 - z^2}$ berechnet wird, wobei d der Relativabstand (d) und z eine in Parallelrichtung zum Leiter (2) gesehene Höhe (z) des zweiten Hallsensors (S$_2$) über der ersten Normalebene (N$_1$) ist, welche Höhe (z) gemäß $z = \frac{|v_d \circ (B_1 \times B_2)|}{|B_1 \times B_2|}$ berechnet wird, wobei v$_d$ der Relativabstandsvektor (v$_d$) ist,

sin Sinusfunktion,
arccos Arkuskosinusfunktion,
B$_2$ zweiter Flussdichtevektor (B$_2$) des Magnetfelds,
∘ Operator für das Skalarprodukt,
v$_d$' in die erste Normalebene (N$_1$) projizierter Relativabstandsvektor der Länge des projizierten Relativabstands (d') und der Richtung vom ersten Hallsensor (S$_1$) zu einem in die erste Normalebene (N$_1$) projizierten Fußpunkt (S$_2$') des zweiten Hallsensors (S$_2$), welcher projizierter Relativabstandsvektor (v$_d$') gemäß $v_d' = v_d + v_z$ berechnet wird, wobei v$_z$ ein Höhenvektor der Länge der Höhe (z) und der Richtung vom zweiten Hallsensor (S$_2$) zum Fußpunkt (S$_2$') ist, welcher Höhenvektor (v$_z$) gemäß $v_z = \frac{B_2 \times B_1}{|B_2 \times B_1|} \cdot z$ berechnet wird,

B$_1$ erster Flussdichtevektor (B$_1$) des Magnetfelds,
× Operator für das Vektorprodukt,
|B$_1$| Betrag des ersten Flussdichtevektors (B$_1$) und
|B$_2$| Betrag des zweiten Flussdichtevektors (B$_2$).

8. Messvorrichtung nach einem der Ansprüche 1 bis 7, **dadurch gekennzeichnet, dass** die Messvorrichtung (1) ferner eine optische Anzeige (5) zum Anzeigen der ermittelten Stromstärke (I) umfasst.

9. Verfahren zum berührungslosen Ermitteln der elektrischen Stromstärke (I) eines stromdurchflossenen Leiters (2), umfassend

dreidimensionales Erfassen (13) eines ersten Flussdichtevektors B$_1$ eines den stromdurchflossenen Leiter (2) umgebenden Magnetfelds mit einem ersten Hallsensor (S$_1$) und eines zweiten Flussdichtevektors (B$_2$) des Magnetfelds mit einem zweiten in einem bekannten Relativabstand (d) vom ersten Hallsensor (S$_1$) an einem Trägerelement (3) montierten Hallsensor (S$_2$);
in einem mit dem ersten und dem zweiten Hallsensor (S$_1$, S$_2$) verbundenen Prozessor (4),

geometrisches Berechnen (14) eines ersten Normalabstands (r$_1$) zwischen dem Leiter (2) und dem ersten Hallsensor (S$_1$) mithilfe des Relativabstands (d) und des erfassten ersten und des erfassten zweiten Flussdichtevektors (B$_1$, B$_2$); und
Ermitteln (15) der Stromstärke (I) mithilfe des berechneten ersten Normalabstands (r$_1$) und des Betrags des erfassten ersten Flussdichtevektors (B$_1$).

**10.** Verfahren nach Anspruch 9, wobei im genannten Schritt des Berechnens (14) der Prozessor (4) ferner einen zweiten Normalabstand ($r_2$) zwischen dem Leiter (2) und dem zweiten Hallsensor ($S_2$) mithilfe des Relativabstands (d) und des erfassten ersten und des erfassten zweiten Flussdichtevektors ($B_1$, $B_2$) geometrisch berechnet, und der genannte Schritt des Ermittelns (15) umfasst:

> Errechnen eines ersten Stromwerts mithilfe des berechneten ersten Normalabstands ($r_1$) und des Betrags des erfassten ersten Flussdichtevektors ($B_1$);
> Errechnen eines zweiten Stromwerts mithilfe des berechneten zweiten Normalabstands ($r_2$) und des Betrags des erfassten zweiten Flussdichtevektors ($B_2$); und
> Ermitteln (15) der Stromstärke (I) als Mittelwert aus dem ersten und dem zweiten Stromwert.

**11.** Verfahren nach Anspruch 9 oder 10, wobei das Verfahren zwischen dem Schritt des Erfassens (13) und dem Schritt des Berechnens (14) jeweils einen Schritt des Filterns (16) der erfassten ersten und zweiten Flussdichtevektoren ($B_1$, $B_2$) mit jeweils einem High-Pass-Filter ($7_1$, $7_2$) umfasst.

**12.** Verfahren nach einem der Ansprüche 9 bis 11, wobei das Verfahren ferner umfasst,
Erfassen (17) eines zeitlichen Verlaufs einer Feldstärke eines den stromdurchflossenen Leiter (2) umgebenden elektrischen Feldes mit einer mit dem Prozessor (4) verbundenen Antenne (8);

> mit dem Prozessor (4),
> Berechnen (18) eines zeitlichen Verlaufs der ermittelten Stromstärke (I); und
> Ermitteln (19) eines Wirkleistungsfaktors aus einer Phasendifferenz zwischen dem berechneten zeitlichen Verlauf der Stromstärke (I) und dem erfassten zeitlichen Verlauf der elektrischen Feldstärke.

**13.** Verfahren nach einem der Ansprüche 9 bis 12, wobei erste Normalabstand gemäß

$$r_1 = \frac{d \cdot \sin\left(90 - \arccos\left(\frac{B_2 \circ v_d}{|B_2| \cdot d}\right)\right)}{\sin\left(\arccos\left(\frac{B_1 \circ v_d}{|B_1| \cdot d}\right) + \arccos\left(\frac{B_2 \circ v_d}{|B_2| \cdot d}\right)\right)}$$

berechnet wird, mit

> d Relativabstand (d),
> sin Sinusfunktion,
> arccos Arkuskosinusfunktion,
> $B_2$ zweiter Flussdichtevektor ($B_2$) des Magnetfelds,
> ∘ Operator für das Skalarprodukt,
> $v_d$ Relativabstandsvektor ($v_d$) der Länge des Relativabstands (d) und der Richtung vom ersten zum zweiten Hallsensor ($S_1$, $S_2$),
> $|B_2|$ Betrag des zweiten Flussdichtevektors ($B_2$),
> $B_1$ erster Flussdichtevektor ($B_1$) des Magnetfelds und
> $|B_1|$ Betrag des ersten Flussdichtevektors ($B_1$).

**14.** Verfahren nach einem der Ansprüche 9 bis 13, wobei der erste Normalabstand gemäß

$$r_1 = \frac{d' \cdot \sin\left(90 - \arccos\left(\frac{B_2 \circ v_d'}{|B_2| \cdot d'}\right)\right)}{\sin\left(\arccos\left(\frac{B_1 \circ v_d'}{|B_1| \cdot d'}\right) + \arccos\left(\frac{B_2 \circ v_d'}{|B_2| \cdot d'}\right)\right)}$$

berechnet wird, mit

d' in eine erste Normalebene ($N_1$) des Leiters (2), die den ersten Hallsensor ($S_1$) enthält, projizierter Relativabstand, welcher gemäß $d' = \sqrt{d^2 - z^2}$ berechnet wird, wobei d der Relativabstand (d) und z eine in Parallelrichtung zum Leiter (2) gesehene Höhe (z) des zweiten Hallsensors ($S_2$) über der ersten Normalebene ($N_1$) ist, welche Höhe z gemäß $z = \dfrac{|v_d \circ (B_1 \times B_2)|}{|B_1 \times B_2|}$ berechnet wird, wobei $v_d$ der Relativabstandsvektor ($v_d$) ist,

sin Sinusfunktion,
arccos Arkuskosinusfunktion,
$B_2$ zweiter Flussdichtevektor ($B_2$) des Magnetfelds,
∘ Operator für das Skalarprodukt,
$v_d$' in die erste Normalebene ($N_1$) projizierter Relativabstandsvektor der Länge des projizierten Relativabstands (d') und der Richtung vom ersten Hallsensor ($S_1$) zu einem in die erste Normalebene ($N_1$) projizierten Fußpunkt ($S_2$') des zweiten Hallsensors ($S_2$), welcher projizierter Relativabstandsvektor ($v_d$') gemäß $v_d' = v_d + v_z$ berechnet wird, wobei $v_z$ ein Höhenvektor der Länge der Höhe (z) und der Richtung vom zweiten Hallsensor ($S_2$) zum Fußpunkt ($S_2$') ist, welcher Höhenvektor ($v_z$) gemäß $v_z = \dfrac{B_2 \times B_1}{|B_2 \times B_1|} \cdot z$ berechnet wird,

$B_1$ erster Flussdichtevektor ($B_1$) des Magnetfelds,
× Operator für das Vektorprodukt,
$|B_1|$ Betrag des ersten Flussdichtevektors ($B_1$) und
$|B_2|$ Betrag des zweiten Flussdichtevektors ($B_2$).

15. Verfahren nach einem der Ansprüche 9 bis 14, wobei das Verfahren ferner umfasst,
Anzeigen (20) der ermittelten Stromstärke an einer optischen Anzeige (5).

**Fig. 1**

**Fig. 2**

*Fig. 3*

*Fig. 4*

*Fig. 5*

Europäisches
Patentamt

European
Patent Office

Office européen
des brevets

# EUROPÄISCHER RECHERCHENBERICHT

Nummer der Anmeldung

EP 25 21 9726

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 2013/124117 A1 (BOSCH GMBH ROBERT [DE]) 29. August 2013 (2013-08-29) * Zusammenfassung * * Seite 6, Zeile 19 - Seite 7, Zeile 1; Abbildung 2 * * Seite 7, Zeile 16 - Zeile 21; Abbildung 3 * * Seite 7, Zeile 27 - Zeile 34; Abbildung 4a * * Seite 8, Zeile 28 - Zeile 36; Abbildung 5 * ----- | 1-15 | INV. G01R15/20 G01R19/00 ADD. G01R21/00 |
| A | US 2022/214383 A1 (TAKENAKA KAZUMA [JP] ET AL) 7. Juli 2022 (2022-07-07) * Absatz [0034] - Absatz [0038]; Abbildung 1 * * Absatz [0047]; Abbildung 2 * * Absätze [0054] - [0057], [0067]; Abbildung 4 * ----- | 1-15 | |
| A | US 2001/052765 A1 (SEIKE TAKASHI [JP]) 20. Dezember 2001 (2001-12-20) * Absatz [0019]; Abbildung 1 * * Absätze [0020], [0021]; Abbildung 2 * ----- | 1,9 | RECHERCHIERTE SACHGEBIETE (IPC) G01R H10N |

Der vorliegende Recherchenbericht wurde für alle Patentansprüche erstellt

| Recherchenort | Abschlußdatum der Recherche | Prüfer |
|---|---|---|
| München | 8. Mai 2026 | Jakob, Clemens |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...............................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 25 21 9726

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-05-2026

| Im Recherchenbericht angeführtes Patentdokument | Datum der Veröffentlichung | Mitglied(er) der Patentfamilie | Datum der Veröffentlichung |
|---|---|---|---|
| WO 2013124117 A1 | 29-08-2013 | CN 104160284 A | 19-11-2014 |
| | | DE 102012202826 A1 | 29-08-2013 |
| | | EP 2817641 A1 | 31-12-2014 |
| | | WO 2013124117 A1 | 29-08-2013 |
| US 2022214383 A1 | 07-07-2022 | EP 3971587 A1 | 23-03-2022 |
| | | JP 7001079 B2 | 19-01-2022 |
| | | JP 2020186991 A | 19-11-2020 |
| | | US 2022214383 A1 | 07-07-2022 |
| | | WO 2020230753 A1 | 19-11-2020 |
| US 2001052765 A1 | 20-12-2001 | CN 1335508 A | 13-02-2002 |
| | | FR 2810409 A1 | 21-12-2001 |
| | | GB 2363854 A | 09-01-2002 |
| | | JP 3327899 B2 | 24-09-2002 |
| | | JP 2002005967 A | 09-01-2002 |
| | | KR 20010113476 A | 28-12-2001 |
| | | TW 512236 B | 01-12-2002 |
| | | US 2001052765 A1 | 20-12-2001 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 102005013232 A1
- US 7719258 B2